Europäisches Patentamt

**European Patent Office**

Office européen des brevets

(11) Publication number: **0 273 120**
**A1**

# EUROPEAN PATENT APPLICATION

(21) Application number: **87114916.7**

(22) Date of filing: **13.10.87**

(51) Int. Cl.⁴ **H03K 17/693** , H03K 3/353

(30) Priority: **28.11.86 US 935882**

(43) Date of publication of application:
**06.07.88 Bulletin 88/27**

(84) Designated Contracting States:
**DE FR GB IT**

(71) Applicant: **International Business Machines
Corporation
Old Orchard Road
Armonk, N.Y. 10504(US)**

(72) Inventor: **Runyon, Stephen Larry
402 Sage Boot Drive
Pflugerville Texas 78660(US)**
Inventor: **Schmookler, Martin Stanley
7504 Rockpoint Drive
Austin Texas 78731(US)**

(74) Representative: **Hawkins, Anthony George
Frederick
IBM United Kingdom Limited Intellectual
Property Department Hursley Park
Winchester Hampshire SO21 2JN(GB)**

(54) **Multiplexor circuit.**

(57) The circuit includes a plurality of input lines (10, 12, 14) that are each connected to switching devices (22, 24, 26) that gate a selected one of the input lines to an internal node (34). Individual control signals control the operation of each of the switching devices connected to the input lines. An inverter (51) is included having an input connected to the internal node (34) to provide the multiplexor circuit output signal. This output signal is an inversion of the received input signal. A feedback circuit (40) is provided to provide a voltage level to this internal node to ensure a low output level in the absence of any gated input signal.

## MULTIPLEXTOR CIRCUIT

This invention relates to multiplexor circuits.

A multiplexor circuit is a circuit that provides an output signal which is a selected one of a number of input signals. In other words, a multiplexor circuit switches between one of several input signals to provide its output signal. Factors that determine the quality of multiplexor circuits are speed, power dissipation, and the number of inputs allowed.

The present invention is directed to a multiplexor circuit that provides greater speed and a large number of possible inputs without excessive power dissipation. The invention includes a feedback means of regulating a voltage level in an internal node in the multiplexor circuit to increase operation speed while limiting power dissipation of the circuit.

Several prior art multiplexor circuits also include the use of feedback. U. S. Patent 3,539,928 entitled "Operational Multiplexor" discloses the use of operational amplifiers with a feedback line to affect the impedance of the selected operational amplifier in relation to the non-selected operational amplifiers.

A second prior art circuit, U. S. Patent 3,624,538 entitled "Time Multiplexor with Feedback", discloses a multiplexing network for analog signals including a feedback path from a common output to individual operational amplifiers at the input of the multiplexor circuit.

A third multiplexor circuit is disclosed in the IBM Technical Disclosure Bulletin, Vol. 16, No. 12, May, 1974, entitled "Diode Circuit-Switch Multiplexor" that discloses a multiplexor that converts analog voltages into analog currents while switching these currents with a very fast diode circuit.

The three previously cited references all address analog signal multiplexing circuits. IBM Technical Disclosure Bulletin, Vol. 23, No. 6, November, 1980, entitled "N-Bit Multiplexor with Test Feature" discloses a digital multiplexing circuit that includes a latch and a feedback path to maintain the state of the latch. However, none of these prior art references address the use of a feedback device as used in the present invention.

In accordance with the present invention there is provided a multiplexor circuit comprising a plurality of input lines each connected to an individual control switch means for gating an input signal on its connected input line to an output line upon the occurrence of a control signal characterised by:

inverter means having an input connected to all output lines of the control switch means and for providing a multiplexor circuit output signal upon receiving the input signal from one of the control switch means; and

feedback means for providing a voltage level to the input to the inverter means.

In a preferred embodiment of the present invention, a multiplexor circuit is provided that includes a plurality of input lines where each input line is connected to a control field effect transistor device. The gates of each of the control field effect transistor devices are individually connected to unique control signals. In the operation of this multiplexor circuit, only one of the control signals is active at a time. The outputs of all the control field effect transistors are connected to a common node. This node is further connected to the input of an inverter circuit that provides the multiplexor circuit output. This output signal is an inversion of the selected input signal. A feedback circuit is also provided that includes a field effect transistor gated by the multiplexor circuit output. The feedback field effect transistor selectively provides a voltage level to the node connected to the input of the inverter means to provide stability of inverter circuit operation.

The invention will now be described, by way of example, with reference to the accompanying figure, wherein:

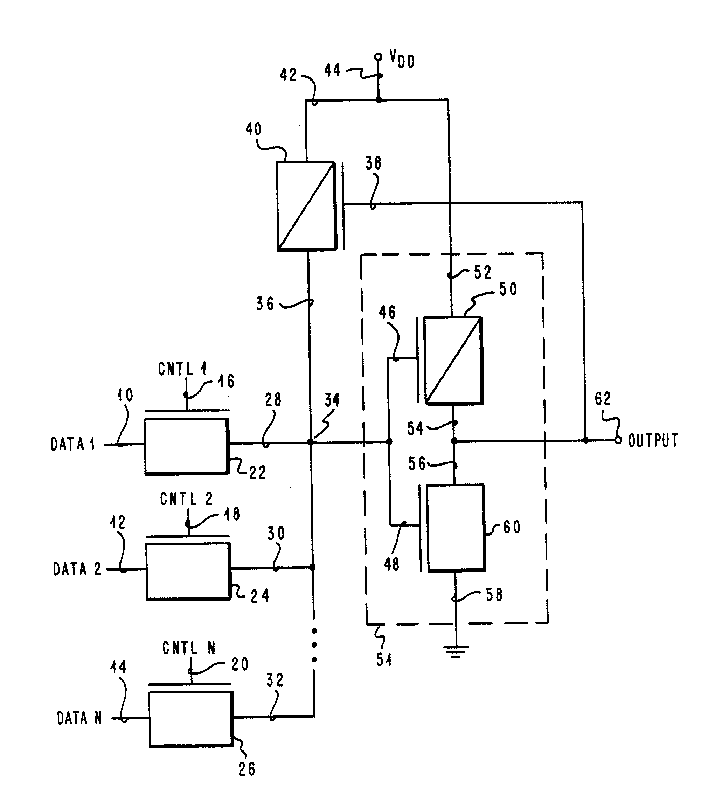

Figure 1 is a schematic diagram of the multiplexor circuit.

In Figure 1 several input lines 10, 12, and 14 are respectively connected to control switches 22, 24 and 26. In the preferred embodiment, control switches 22, 24, and 26 are field effect transistors. These control switches 22, 24 and 26 are connected to receive control signals on lines 16, 18 and 20 respectively. In operation, only one control signal will be provided at a time and therefore, only one input line will be selected at a time. The control switches 22, 24 and 26 are connected to output lines 28, 30 and 32 respectively which are in turn connected to a node 34.

Node 34 is connected to the input of an inverter circuit 51. The inverter 51 includes two field effect transistors 50 and 60. In the preferred embodiment, field effect transistor 50 is a P-channel device and field effect transistor 60 is a N-channel device. These two transistors 50 and 60 include gates that are connected to node 34 through lines 46 and 48. The drain 54 of transistor 50 and the drain 56 of transistor 60 are connected to the output node 62 through lines 54 and 56. The source 52 of transistor 50 is connected to a node 44 which is connected to the voltage potential $V_{DD}$. The source 58 of device 60 is connected to ground as shown.

The multiplexor circuit also includes a feedback device 40 consisting of a P-channel transistor having a gate 38 connected to the output node 62 through a line 38 and a source connected to node 44 through a line 42. The drain of transistor 40 is connected to node 34 through a line 36.

In Figure 1, transistors 50 and 60 form an inverter to provide a high output drive capability. The switching transistors 22, 24 and 26 are the input pass gates to input a single selected input signal to node 34. The feedback transistor 40 provides a feedback voltage to overcome the input level degradation due to the shift of the threshold voltage $-V_T$ at internal node 34 when the input signal level is high. This voltage shift may cause the P-channel inverter transistor 50 to remain biased on when the input is high resulting in a DC power dissipation and an uncertain output level. The addition of this extra transistor 40 allows the internal node 34 to be pulled up to a level higher than $V_{DD} - V_T$ necessary to turn off the transistor 50 fully. When the output 62 begins to switch low, device 40 will begin to conduct current as soon as the output falls below $V_{DD} - V_T$, thus pulling the internal node 34 up to a voltage sufficient to insure that transistor 50 is fully turned off and the output is a valid down level. Transistor 40 should be small enough to allow the circuits driving the input lines 10, 12 and 14 to pull down the internal node 34 when they are selected. By allowing only one control line 16, 18 or 20 to be active at a time, the flow of DC current through the circuit is prevented which could cause an undefined output level.

This design offers a multiplexing circuit function with a fewer number of devices that will result in a greater increased circuit density in an integrated circuit.

In many current designs, multiplexor circuits are provided that include the stacking of transistors for additional inputs resulting in a deterioration in circuit performance. The stacking of devices also limits the number of inputs allowable because of the channel resistances that are in series. This invention is theoretically unlimited as to the number of inputs allowable because these channel resistances are now effectively in parallel. However, each additional input line does add some capacitance to the internal node 34 and would thus slow down the operation of the multiplexing circuit somewhat, although the performance impact is less than what would exist with certain current designs. It should be understood that the circuit also is designed to use CMOS technology so that the power that is used is solely a function of the switching speeds of the multiplexor circuit.

## Claims

1. A multiplexor circuit comprising a plurality of input lines (10, 12, 14) each connected to an individual control switch means (16, 18, 20) for gating an input signal on its connected input line to an output line upon the occurrence of a control signal characterised by:
inverter means (50, 60) having an input connected to all output lines of the control switch means and for providing a multiplexor circuit output signal upon receiving the input signal from one of the control switch means; and
feedback means (40) for providing a voltage level to the input to the inverter means.

2. A multiplexor circuit according to Claim 1 wherein each said control switch means include a field effect transistor with a gate terminal connected to receive the control signal.

3. A multiplexor circuit according to Claim 1 or Claim 2 wherein said inverter means includes two field effect transistors of opposite channel polarities.

4. A multiplexor circuit according to Claim 3 wherein a first of said inverter field effect transistors is connected to a voltage source and the second field effect transistor is connected to a ground potential.

5. A multiplexor circuit according to Claim 3 or Claim 4 wherein said inverter field effect transistors each include gates connected to the switching means output.

6. A multiplexor circuit according to any one of the previous Claims wherein said feedback means includes a field effect transistor having one terminal connected to the voltage source and another terminal connected to the input to the inverter means and further having a gate connected to the output of the inverter means.

7. A multiplexor circuit for providing a circuit output signal that is an inversion of a selected one of a plurality of input signals and wherein only one input signal is selected at any time, said multiplexor circuit characterised by:
a plurality of input lines (10, 12, 14) each connected to receive said input signals and each further connected to a switching device (22, 24, 26) for passing its received input signal to a node connecting outputs of all switching devices when the switching device receives a control signal;
inverter means (50, 60) connected to the node for providing the circuit output signal upon receiving the selected input signal; and
feedback means (40) connected to the circuit output for selectively providing a voltage level to the node.

8. A multiplexor circuit according to Claim 7 wherein said switching devices each include a field effect transistor with a gate terminal connected to receive the control signal.

9. A multiplexor circuit according to Claim 7 or Claim 8 wherein said inverter means includes two field effect transistors of opposite channel polarities.

10. A multiplexor circuit according to Claim 9 wherein a first of said inverter field effect transistors is connected to a voltage source and the second field effect transistor is connected to a ground potential.

11. A multiplexor circuit according to Claim 9 or Claim 10 wherein said inverter field effect transistors each include gates connected to the node.

12. A multiplexor circuit according to any of Claims 7 to 11 wherein said feedback means includes a field effect transistor having one terminal connected to the voltage source and another terminal connected to the node and further having a gate connected to the output of the inverter means.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 10, no. 95 (E-395)[2152] 12th April 1986; & JP-A-60 236 322 (MITSUBISHI DENKI K.K.) 25-11-1985 * Abstract * --- | 1-12 | H 03 K   17/693 H 03 K    3/353 |
| X | PATENT ABSTRACTS OF JAPAN, vol. 9, no. 165 (E-327)[1888] 10th July 1985; JP-A-60 38 924 (HITACHI SEISAKUSHO K.K.) 28-02-1985 * Abstract * ----- | 1-12 | |

TECHNICAL FIELDS
SEARCHED (Int. Cl.4)

H 03 K

The present search report has been drawn up for all claims

| Place of search | Date of completion of the search | Examiner |
|---|---|---|
| THE HAGUE | 29-02-1988 | CANTARELLI R.J.H. |

EPO FORM 1503 03.82 (P0401)